# EUROPEAN PATENT APPLICATION

(11) **EP 4 353 396 A1**
(43) Date of publication of application: **17.04.2024**
(21) Application number: 22820626.4
(22) Date of filing: 13.06.2022
(51) Int. Cl.: B23K 26/0622, H05K 7/20, B23K 26/08, B23K 103/10

(54) **METHOD FOR FORMING WICK PART FOR VAPOR CHAMBER, AND METHOD FOR MANUFACTURING VAPOR CHAMBER**

(30) Priority: 11.06.2021 KR 20210076257
(71) Applicant: KMW Inc., Hwaseong-si, Gyeonggi-do 18462 (KR)
(72) Inventor: CHO, Hang Hyeon, Yongin-si, Gyeonggi-do 16998 (KR); LEE, Jong Min, Incheon 21377 (KR); JANG, Jae Ho, Pohang-si, Gyeongsangbuk-do 37586 (KR); LEE, Kang Hyun, Hwaseong-si, Gyeonggi-do 18442 (KR)
(74) Representative: SJW Patentanwälte
(86) International application number: PCT/KR2022/008279
(87) International publication number: WO 2022/260499

(57) **Abstract**

Provided are a method for forming a wick part for a vapor chamber and a method for manufacturing the vapor chamber. The method for forming the wick part for the vapor chamber includes a base material preparation step for preparing a base material of a chamber body in which a refrigerant is accommodated, a laser installation step for setting a laser emitter on one side of the base material prepared in the base material preparation step, and a wick part processing step for processing a wick part having a predetermined size into a predetermined engraved pattern by means of a predetermined emitted laser beam by using the laser emitter installed in the laser installation step, thereby providing the advantage of being able to improve the product productivity of the vapor chamber.

## Description

### [Technical Field]

The present disclosure relates to a method for forming a wick part for a vapor chamber and a method for manufacturing the vapor chamber, and more specifically, to a method for forming a wick part for a vapor chamber and a method for manufacturing the vapor chamber, which can precisely and quickly form a wick part on a base material made of aluminum by using a laser emitter.

### [Background Art]

In general, electronic components constituting an electronic device generate heat when operating. For example, an electronic device such as a computer, a server, and a high-performance antenna device includes an IC chip, a CPU, and transmission/reception elements, and such electronic components generate a large amount of heat when operating. An electronic component that generates heat (hereinafter, referred to as 'heat-generating element') needs to be cooled, and when the heat-generating element is not cooled, the performance of the heat-generating element may be significantly deteriorated or the heat-generating element may be damaged and fail to operate in some cases.

In recent electronic devices, a spacing between components is narrowing and a heat-generating load is increasing due to slimness, high integration, and high performance. Accordingly, cooling of a heat-generating element is almost essential, and most electronic devices are provided with cooling devices for cooling heat-generating elements.

Types of cooling devices include an air cooling system that cools surrounding air by circulating the surrounding air and a refrigerant system that cools a refrigerant by circulating the refrigerant. The air cooling system needs to be essentially provided with a blowing fan that actively circulates air, and the refrigerant system needs to be essentially provided with a compressor that compresses a gaseous refrigerant in order to cause a phase change in the refrigerant.

The essential requirements for the blowing fan and the compressor not only increase the size of an electronic device, but also increase power consumption.

Accordingly, recently, heat-pipe type or vapor chamber type cooling devices, in which a predetermined refrigerant is circulated while changing a phase according to difference in the surrounding temperatures even without a compressor, are widely used.

In the heat-pipe type or vapor chamber type cooling devices, a hollow (or an internal space) is formed, and a capillary wick part, which is a porous body, is manufactured by a sintering method inside a body tube (or a body panel) of a pipe shape (or a panel) made of a heat conductive material.

However, since the capillary wick part is manufactured only by a sintering method, there are various limitations in a sintering process, a sintering condition, and the like, resulting in a problem that the productivity of a product is reduced.

### [Disclosure]

### [Technical Problem]

The present disclosure is directed to providing a method for forming a wick part for a vapor chamber and a method for manufacturing the vapor chamber, which can improve the productivity of a product by forming the shape of a capillary wick part using a laser.

The present disclosure is directed to providing a method for forming a wick part for a vapor chamber and a method for manufacturing the vapor chamber, which can secure variety of a heat dissipation design by manufacturing a wick part having various pattern shapes by using a laser emitter.

Objects of the present disclosure are not limited to the above-described objects, and other objects that are not mentioned will be able to be clearly understood by those skilled in the art from the following description.

### [Technical Solution]

In order to achieve the objects, a method for forming a wick part for a vapor chamber according to the present disclosure includes: a base material preparation step for preparing a base material of a chamber body in which a refrigerant is accommodated; a laser installation step for setting a laser emitter on one side of the base material prepared in the base material preparation step; and a wick part processing step for processing a wick part having a predetermined size into a predetermined engraved pattern by means of a predetermined emitted laser beam by using the laser emitter installed in the laser installation step.

In the wick part processing step, a movement time of the laser beam may be set to a predetermined mark speed.

The mark speed may be set to 300 mm/s.

In the wick part processing step, an oscillation frequency of the laser beam may be set within a range of 20 kHz to 40 kHz, and the laser beam may be oscillated in a pulse mode.

A line spacing at which the laser beam is emitted may be 0.1 mm at maximum.

The wick part formed on the base material by the laser emitter may be processed into any one pattern of a cross shape, a block shape, and a ' 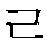 ' shape.

A method for manufacturing the vapor chamber according to an embodiment of the present disclosure includes: a base material preparation step for preparing a base material of the chamber body in which a refrigerant is accommodated; a laser installation step for setting a laser emitter on one side of the base material prepared in the base material preparation step; a wick part processing step for processing a wick part having a predetermined size into a predetermined engraved pattern by means of a predetermined emitted laser beam by using the laser emitter installed in the laser installation step; and a wick body coupling step for coupling, to an inner surface of the chamber body, an outer surface being a processed flat surface of a wick body formed to cover the wick part formed in the wick part processing step and formed of a porous body to include a plurality of pores through a sintering process.

The wick body coupling step may be a step for coupling the wick part formed on the inner surface of the chamber body and at least some of the plurality of pores exposed to a surface of the wick body to communicate with each other.

### [Advantageous Effects]

A method for forming a wick part for a vapor chamber and a method for manufacturing the vapor chamber according to the present disclosure can achieve the following various effects.

First, since it is not necessary to rely solely on a sintering method in forming a wick part that forms a capillary force, restrictions such as sintering conditions are eliminated and a vapor chamber can be manufactured quickly.

Second, the precise adjustment of a laser facilitates the formation of the wick part for the vapor chamber having a capillary tube (capillary) effect.

Third, the size of the wick part can be precisely adjusted in consideration of the type of refrigerant used and the surface tension of a material itself, thereby improving the heat dissipation performance of a product.

Fourth, as the wick part is formed on the inner surface of a chamber body in the form of an engraved pattern, a contact area with a refrigerant is relatively increased as an area through which the refrigerant flows while changing a phase, thereby improving heat dissipation performance.

### [Description of Drawings]

FIG. 1 is a flowchart showing a method for forming a wick part for a vapor chamber according to an embodiment of the present disclosure.
FIG. 2 is a plan view showing the vapor chamber according to an embodiment of the present disclosure.
FIG. 3 is a cross-sectional view taken along line A-A of FIG. 2 and is a cross-sectional view for explaining the principle of heat transfer through the vapor chamber.
FIG. 4 is an actual pattern photograph using a laser emitter in FIG. 1 and is a partial enlarged view thereof.
FIG. 5 is a plan view showing a line spacing using the laser emitter in FIG. 1.
FIGS. 6A and 6B are planar photographs showing an example of a pattern shape of a wick part formed in a base material by the laser emitter in FIG. 1.

### <Description of reference numerals>

10: Vapor chamber 20: Chamber body
30: Wick body S10: Base material preparation step
S20: Laser installation step S30: Wick part processing step
P: Wick part

### [Mode for Invention]

Hereinafter, a method for forming a wick part for a vapor chamber and a method for manufacturing the vapor chamber according to an embodiment of the present disclosure will be described in detail with reference to the accompanying drawings.

It is to be noted that in assigning reference numerals to elements in the drawings, the same reference numerals denote the same elements throughout the drawings even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of the embodiments the present disclosure, terms, such as the first, the second, A, B, (a), and (b) may be used. However, the terms are used only to distinguish one element from the other element, and the essence, order, or sequence of the elements are not limited by the terms. Furthermore, unless otherwise defined, all terms used herein including technical or scientific terms have the same meanings as the terms generally understood by those skilled in the art to which the present disclosure pertains. The terms, such as terms defined in dictionaries, which are generally used, should be interpreted as having meanings identical to contextual meanings of the related art, and are not interpreted as ideal or excessively formal meanings unless they are definitely defined in the present disclosure.

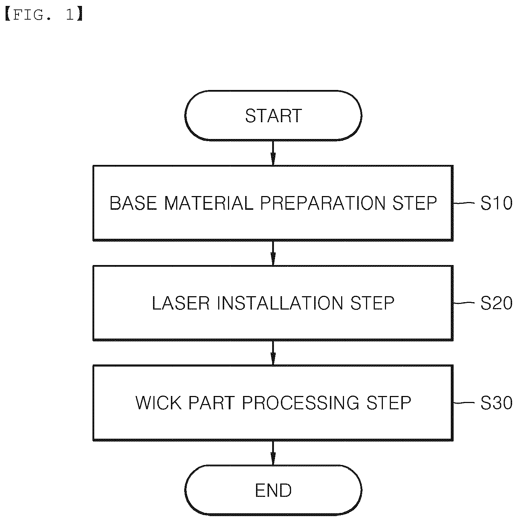

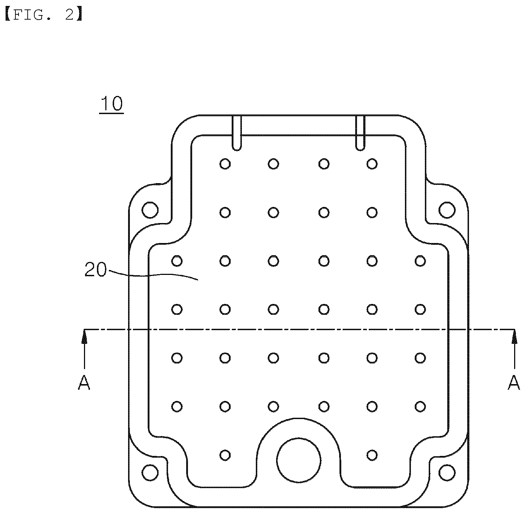

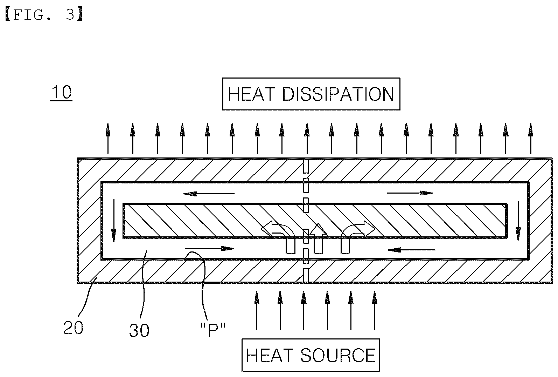

FIG. 1 is a flowchart showing a method for forming a wick part for a vapor chamber according to an embodiment of the present disclosure, FIG. 2 is a plan view showing a vapor chamber according to an embodiment of the present disclosure, and FIG. 3 is a cross-sectional view taken along line A-A of FIG. 2 and is a cross-sectional view for explaining the principle of heat transfer through a vapor chamber.

The vapor chamber being the final product of an embodiment of the present disclosure is one of heat dissipation components that can employ a heat dissipation method with a concept of excluding the induction of a phase change of a refrigerant by a compressor, and is a representative radiator designed to cool a specific heat generating element that is electrically driven and generates heat by transferring heat while causing a phase change solely by heat supplied from the outside at an atmospheric pressure state without using a compressor.

More specifically, as shown in FIG. 2, a vapor chamber 10 may include a chamber body 20 that forms a predetermined vacuum space therein and accommodates a refrigerant, and a wick body 30 coupled to an interior of the chamber body 20 and including a porous body formed with a plurality of pores for flowing the refrigerant filled therein.

As shown in FIG. 3, an outer surface of the wick body 30 is cut to have a flat surface to be in close contact with an inner surface of the chamber body 20, and the refrigerant may be filled between the chamber body 20 and the wick body 30 and may flow as described above.

The plurality of pores formed in the wick body 30 serve to flow a gaseous refrigerant or to discharge a liquid refrigerant, which is discharged to the outside due to its own surface tension, to each wick part (see reference numeral "P" in FIG. 3) formed in the chamber body 20, which will be described below. The liquid refrigerant discharged through each wick part P may be moved in one direction or the other direction through a wick part formed in a wick part processing step S30 to be described below along between at least the inner surface of the chamber body 20 and the outer surface of the wick body 30.

More specifically, the wick body 30 is a part generated by a sintering method, is formed of a porous body to have a capillary tube, and may serve as a passage that increases a thermal contact area of a stored refrigerant to promote a phase change from a liquid refrigerant to a gaseous refrigerant and to allow a refrigerant changed to the gaseous refrigerant to pass therethrough.

For example, as shown in FIG. 3, the present disclosure uses the principle that when heat is transferred inward through the chamber body 20 by a predetermined heat source provided on one side in a thickness direction of the chamber body 20, the refrigerant filled inside is changed into a liquid state while changing a phase by heat transferred and is discharged to the outside of the pores in the thickness direction of the chamber body 20, the liquid refrigerant transfers heat to the other side in the thickness direction of the chamber body 20 via a wick part P having a predetermined shape by surface tension and capillary force and is moved along the inner surface of the chamber body 20, and the heat transferred to the other side in the thickness direction of the chamber body 20 is dissipated to the outside.

In particular, as an important element for forming the capillary force, a fluid path having a certain size needs to be formed on the inner surface of the chamber body 20, with which the outer surface of the wick body 30 is in close contact, in a direction horizontal to the inner surface of the chamber body 20, and the size of the fluid path is preferably designed in consideration of the surface tension (or anti-gravity) of a fluid used as a refrigerant.

The refrigerant filled between the chamber body 20 and the wick body 30 may include any one of acetone, ammonia, and distilled water. Since the size of surface tension or anti-gravity varies depending on the type of refrigerant filled, it is necessary to appropriately design and change the size of a depth and a width of a pattern formed in the wick part processing step S30 to be described below.

An embodiment of the present disclosure discloses important technical features of a method for forming a wick part for the wick body 30 provided inside the vapor chamber 10.

As shown in FIG. 1, the method for forming the wick part for the vapor chamber according to an embodiment of the present disclosure includes a base material preparation step S10 for preparing a base material of the chamber body 20 constituting the wick body 30 among the components of the vapor chamber, a laser installation step S20 for setting a laser emitter on one side of the base material prepared in the base material preparation step S10, and a wick part processing step S30 for processing a wick part P having a predetermined shape by means of a predetermined emitted laser beam by using the laser emitter installed in the laser installation step S20.

As shown in FIG. 3, the base material preparation step S10 may be defined as a step for preparing, as a base material constituting the chamber body 20, a thermally conductive material (in particular, an aluminum material) before the wick part P is formed by the laser emitter to be described below.

In the related art, the wick body 30 formed with a plurality of pores manufactured through a sintering process was used as a base material, the outer surface of the wick body 30 was cut into a flat surface, and then a wick part was formed on the cut flat surface. However, there was a complexity in a process in which the wick body 30 being the base material for forming the wick part needs to be manufactured through a sintering process.

However, in the case of the method for forming the wick part for the vapor chamber according to an embodiment of the present disclosure, the base material from which the wick part P is formed is set to the chamber body 20 instead of the wick body 30, and a very simple processing method using a laser beam is adopted, thereby providing the advantage of being able to manufacture the wick body 30 with a more precise and simple process.

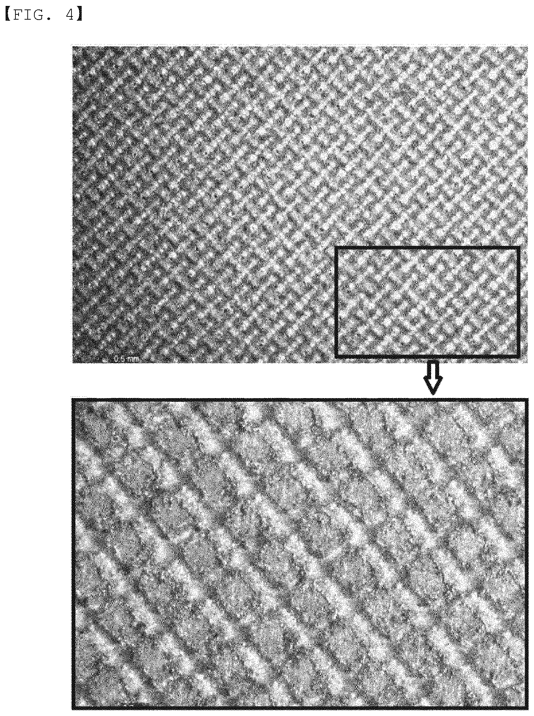

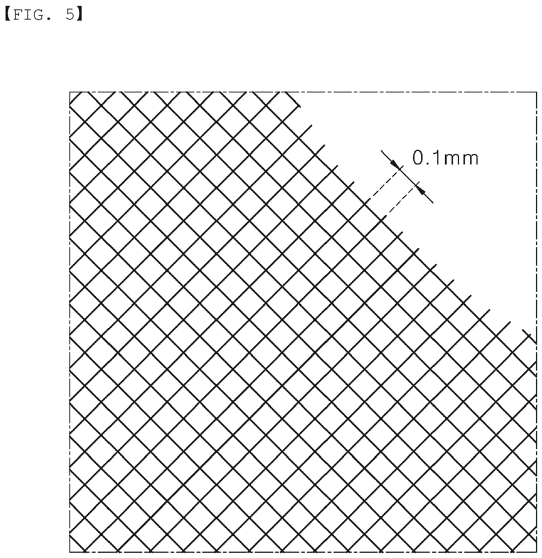

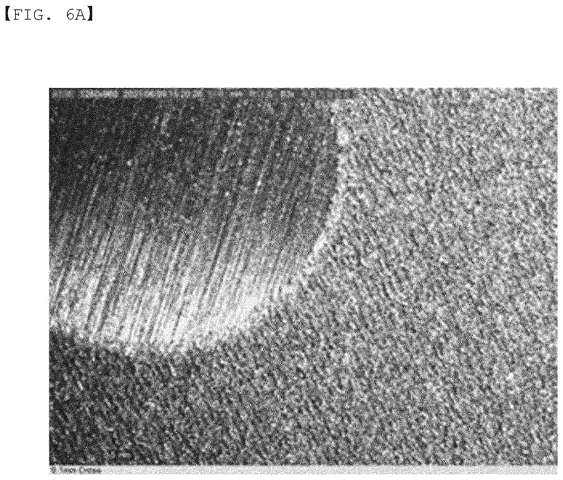

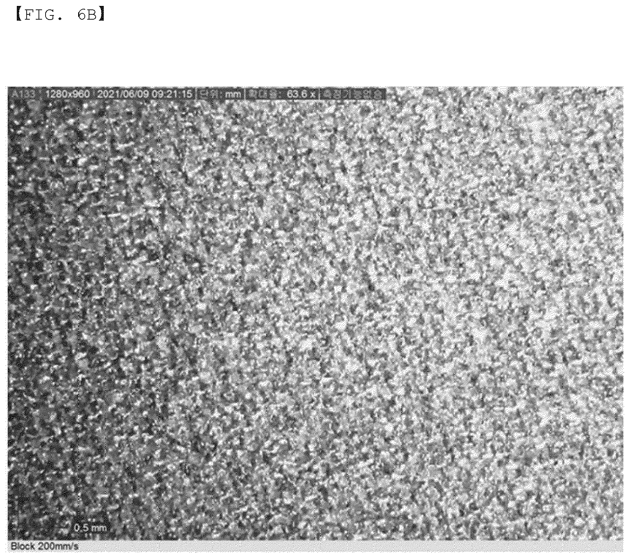

FIG. 4 is an actual pattern photograph using a laser emitter in FIG. 1 and is a partial enlarged view thereof, FIG. 5 is a plan view showing a line spacing using the laser emitter in FIG. 1, and FIGS. 6A and 6B are planar photographs showing an example of a pattern shape of a wick part formed in a base material by the laser emitter in FIG. 1.

The laser installation step S20 is a step for installing and setting a laser emitter that emits a laser beam with a predetermined beam width.

That is, although not shown in the drawings, the laser installation step S20 may be a step for fixing the chamber body 20 being the base material on a processing lathe, installing a laser emitter capable of emitting a laser beam with a predetermined beam width on the processing lathe, and setting a movement speed and a movement direction for laser beam emission of the laser emitter according to a pattern shape to be described below.

The wick part processing step S30 may be a step for setting the movement time of the laser beam to a predetermined mark speed and processing the wick part P in the form of an engraved pattern on one side of the base material corresponding to the inner surface of the chamber body 20.

In this case, the mark speed may be set to 300 mm/s. When the mark speed exceeds 300 mm/s and is set to move too fast, the amount of heat transferred to the base material in the form of a laser beam is too small to form a desired pattern shape. When the mark speed is less than 300 mm/s and is set to move too slowly, the amount of heat transferred to the base material in the form of a laser beam is too large, causing a problem that the shape of the base material is deformed larger than the size of a required wick part.

Compared to the wick part formed on the flat surface of the wick body 30 manufactured through a sintering process in the related art, since the wick part processing step S30 is a step for processing and forming the wick part into a predetermined engraved pattern shape on a portion corresponding to the inner surface of the chamber body 20, there is an advantage that a contact area with a refrigerant increases more than before. Although an increase in the contact area with the refrigerant is slight, the heat dissipation performance of a product is improved.

In the wick part processing step S30, an oscillation frequency of the laser beam is set within a range of 20 kHz to 40 kHz, and the laser beam may be oscillated in a pulse mode. In particular, when the chamber body 20 being the base material is made of aluminum, the most appropriate oscillation frequency of the laser beam of the laser emitter for forming the wick part P is in the range of 20 kHz to 40 kHz as described above.

A line spacing at which the laser beam is emitted may be 0.1 mm at maximum as shown in FIG. 5.

When the line spacing is too wide (that is, exceeds 0.1 mm), there is no capillary force and no water path exists, so anti-gravity characteristics are not implemented. When the capillary force between the chamber body 20 and the wick body 30 is small, the heat source part always needs to be placed in a low position in consideration of the flow of a refrigerant due to changes in an internal temperature, and the heat dissipation part always needs to be placed in a high position, that is, design limitations occur.

Therefore, the line spacing at which the laser beam is emitted is preferably designed to be in a range in which the capillary force is generated, and 0.1 mm, which is one resultant value for removing restrictions on the position of the heat source and the heat dissipation position and is the line spacing at which the laser beam is emitted, has important technical significance.

The wick part P formed on the wick body 30 by the laser emitter may be processed into not only a checkered pattern as shown in FIG. 4, but also any one of a cross pattern as shown in FIG. 6A and a block pattern as shown in FIG. 6B.

Although not shown in the drawings, it is natural that the wick part P may be processed into a pattern shape having a ' 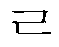 ' shape that continues continuously from the heat source part to the heat dissipation part.

As described above, the method for forming the wick part for the vapor chamber according to an embodiment of the present disclosure allows the wick part P to be precisely and quickly formed using a laser emitter, thereby providing the advantage of greatly improving the productivity of a product.

The method for manufacturing the vapor chamber according to an embodiment of the present disclosure further includes a wick body coupling step (not indicated by reference numeral) for coupling the wick body 30 to the inner surface of the chamber body 20 including the wick part P processed into a pattern shape by the method for forming the wick part for the vapor chamber.

More specifically, the method for manufacturing the vapor chamber according to an embodiment of the present disclosure may include the base material preparation step S10, and the laser installation step S20 for setting the laser emitter on one side of the base material prepared in the base material preparation step S10, and may further perform the wick body coupling step for coupling the wick body 30 formed of a porous body to include a plurality of pores to the inner surface of the chamber body 20 where the wick part P is formed into any one of the above-described checkered pattern, cross pattern, block pattern, and ' 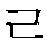 ' pattern shapes through the wick part processing step S30 using the laser emitter installed in the laser installation step S20.

The wick body coupling step may be a step for coupling the wick part P formed on the inner surface of the chamber body 20 and at least some of the plurality of pores exposed to the surface of the wick body 30 to communicate with each other.

The wick body 30 may be manufactured through a sintering process in order to be formed as a porous body including the plurality of pores.

More specifically, the wick body 30 is prepared in the form of a powder of a wick raw material made of a predetermined metal material (for example, copper (Cu) material). At this time, the wick raw material is preferably used with a particle size of 30 um to 300 um and a purity of 90% to 99%.

The sintering temperature condition may vary depending on whether additives are added to the wick raw material, but the most preferred condition may be that the sintering temperature after adding a predetermined amount of glass frit among the additives is 350°C/2hr to 550°C/2hr.

In accordance with the method for forming the wick part for the vapor chamber and the method for manufacturing the vapor chamber according to an embodiment of the present disclosure, which includes the above configuration or process, instead of the method (process) for forming the wick part through a sintering process when manufacturing the wick body in the related art, the wick part P may be formed in a pattern shape using a more precise laser emitter on the inner surface of the chamber body 20 where a capillary force may be formed between the wick body 3 and the chamber body 20, thereby providing a process advantage and improving heat dissipation performance.

In addition, the method for forming the wick part for the vapor chamber and the method for manufacturing the vapor chamber according to an embodiment of the present disclosure enable the manufacturing of the wick part P having a capillary tube (capillary) effect through precise adjustment of a laser, thereby providing the advantage of enabling active design changes depending on the type of refrigerant used.

So far, a method for forming a wick part for a vapor chamber and a method for manufacturing the vapor chamber according to an embodiment of the present disclosure have been described in detail with reference to the attached drawings. However, embodiments of the present disclosure are not necessarily limited to the above-described embodiment, and it is natural that various modifications and equivalent implementations can be made by those skilled in the art to which the present disclosure pertains. Accordingly, the true scope of the present disclosure should be defined by the appended claims.

### [Industrial Applicability]

The present disclosure provides a method for forming a wick part for a vapor chamber and a method for manufacturing the vapor chamber, which can improve the productivity of a product by forming the shape of a capillary wick part using a laser, and can secure variety of a heat dissipation design.

## Claims

1. A method for forming a wick part for a vapor chamber, the method comprising:
a base material preparation step for preparing a base material of a chamber body in which a refrigerant is accommodated;
a laser installation step for setting a laser emitter on one side of the base material prepared in the base material preparation step; and
a wick part processing step for processing a wick part having a predetermined size into a predetermined engraved pattern by means of a predetermined emitted laser beam by using the laser emitter installed in the laser installation step.

2. The method of claim 1, wherein, in the wick part processing step, a movement time of the laser beam is set to a predetermined mark speed.

3. The method of claim 2, wherein the mark speed is set to 300 mm/s.

4. The method of claim 1, wherein, in the wick part processing step, an oscillation frequency of the laser beam is set within a range of 20 kHz to 40 kHz, and the laser beam is oscillated in a pulse mode.

5. The method of claim 1, wherein a line spacing at which the laser beam is emitted is set not to exceed 0.1 mm at maximum.

6. The method of claim 1, wherein the wick part formed on the base material by the laser emitter is processed into any one pattern of a cross shape, a block shape, and a ' 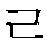 ' shape.

7. A method for manufacturing a vapor chamber, the method comprising:
a base material preparation step for preparing a base material of the chamber body in which a refrigerant is accommodated;
a laser installation step for setting a laser emitter on one side of the base material prepared in the base material preparation step;
a wick part processing step for processing a wick part having a predetermined size into a predetermined engraved pattern by means of a predetermined emitted laser beam by using the laser emitter installed in the laser installation step; and
a wick body coupling step for coupling, to an inner surface of the chamber body, an outer surface being a processed flat surface of a wick body formed to cover the wick part formed in the wick part processing step and formed of a porous body to include a plurality of pores through a sintering process.

8. The method of claim 7, wherein the wick body coupling step is a step for coupling the wick part formed on the inner surface of the chamber body and at least some of the plurality of pores exposed to a surface of the wick body to communicate with each other.
